(19)

Europäisches Patentamt

European Patent Office

Office européen des brevets

(11) **EP 4 628 952 A1**

(12) **EUROPEAN PATENT APPLICATION**
published in accordance with Art. 153(4) EPC

(43) Date of publication:
**08.10.2025 Bulletin 2025/41**

(21) Application number: **22967721.6**

(22) Date of filing: **31.12.2022**

(51) International Patent Classification (IPC):
***G02B 6/293*** (2006.01)    ***H01S 3/08*** (2023.01)

(52) Cooperative Patent Classification (CPC):
**G02B 6/293; H01S 3/08**

(86) International application number:
**PCT/CN2022/144399**

(87) International publication number:
**WO 2024/119575 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.12.2022 CN 202211565246**

(71) Applicant: **Silith Technology (Suzhou) Co., Ltd.
Shanghai 201210 (CN)**

(72) Inventor: **ZHANG, Xingyu
Shanghai 201210 (CN)**

(74) Representative: **Bayramoglu et al.
Mira Office
Kanuni Sultan Süleyman Boulevard 5387
Street Beytepe, floor 12, no:50
06800 Cankaya, Ankara (TR)**

(54) **RESONATOR SYSTEM, TUNABLE LASER DEVICE, AND CONTROL METHOD FOR RESONATOR SYSTEM**

(57)    The present invention provides a resonator system, including N resonator stages cascaded, where N is an integer greater than 1. Each of the resonator stages includes a resonant cavity and a thermal phase shifter. In each of the resonator stages, the thermal phase shifter is integrated on the resonant cavity. The thermal phase shifters in the N resonator stages cascaded are sequentially connected in series. A first end of the thermal phase shifter in a first resonator stage is connected to a preset voltage, a second end of the thermal phase shifter in an $N^{th}$ resonator stage is grounded, and a connection node of the thermal phase shifters in adjacent resonators stages is connected to an adjustable voltage, wherein resistances of the thermal phase shifters in the N resonator stages are all equal. The resonator system according to the present invention enables that a change in a phase difference between adjacent resonant cavities can be linearly proportional to a control voltage connected to the connection node of the thermal phase shifters in the adjacent resonator stages, which simplifies a control method for a vernier micro-ring resonator and reduces the number of control voltages required. The present invention further provides a tunable laser and a control method for a resonator system.

FIG. 3

EP 4 628 952 A1

**Description**

**TECHNICAL FIELD**

The present invention relates to the technical field of resonators, in particular to a resonator system, a tunable laser, and a control method for the resonator system.

**BACKGROUND**

A micro-resonator based on a vernier effect is composed of two or more sub-resonators with different free spectral ranges and has a free spectral range being a least common multiple of the free spectral ranges of the two or more sub-resonators. The micro-resonator enables the expansion of the free spectral range and is suitable for some applications with requirements for wide spectrum and high sensitivity, such as tunable lasers, tunable filters, and high-sensitivity sensors.

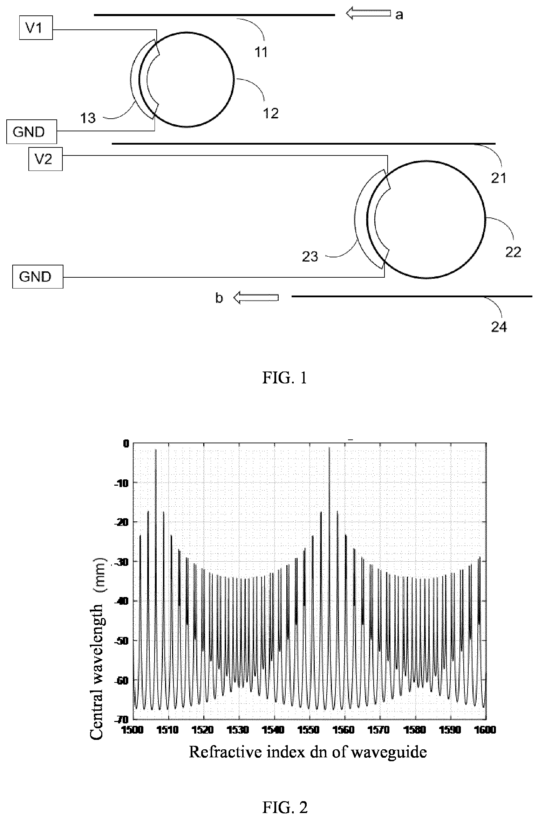

FIG. 1 is a schematic diagram of tunable micro-resonators based on a vernier effect in the prior art. A first micro-resonator stage and a second micro-resonator stage are cascaded together to form a vernier micro-resonator. The first micro-resonator stage and the second micro-resonator stage are different in size. The first micro-resonator stage includes a first optical waveguide 11, a first micro-resonator cavity 12 and a first thermal phase shifter 13. The second micro-resonator stage includes a second optical waveguide 21, a second micro-resonator cavity 22, and a second thermal phase shifter 23. The first micro-resonator cavity 12 is coupled to the first optical waveguide 11 and the second optical waveguide 21, and the second micro-resonator cavity 22 is coupled to the second optical waveguide 21 and the output optical waveguide 24. The arrow with a label "a" is a light transmission direction of an optical path in the first optical waveguide 11, and the arrow with a label "b" is a light transmission direction of an optical path in the output optical waveguide. One end of the first thermal phase shifter and one end of the second thermal phase shifter are connected to a control voltage V1 or V2, while the other end of the first thermal phase shifter and the other end of the second thermal phase shifter are grounded. Two micro-resonators are controlled by control voltages V1 and V2 respectively. The thermal phase shifter is based on the working principle of a heating resistor. When the voltage V1 (or V2) is loaded to the thermal phase shifter with a resistance R1 (or R2), heat of $V1^2/R1$ (or $V2^2/R2$) is produced, which changes the refractive index of an optical waveguide thereof. Because the change in phase is directly proportional to the change in refractive index, that is $\Delta\varphi \propto dn$, the optical phase of the micro-resonator is changed, resulting in spectral translation. The two voltages V1 and V2 can be adjusted to control the final spectral shape of the vernier micro-resonator, such as to change the central wavelength. FIG. 2 is an output spectrum of a vernier micro-resonator at voltages V1 and V2 in the prior art. In the above vernier micro-resonator, the two voltages V1 and V2 need to be both controlled to be appropriate, such that the wavelengths of the spectra of two micro-rings are controlled to be the central wavelength required through the vernier effect. The two voltages need to be both controlled, and the change in phase of each micro-ring is directly proportional to the square of the voltage, making the control algorithm complex.

Therefore, it is necessary to provide a novel resonator system, a tunable laser and a control method for the resonator system to solve the above problems in the prior art.

**SUMMARY**

An objective of the present invention is to provide a resonator system, a tunable laser, and a control method for the resonator system. It can be achieved that a change in a phase difference between adjacent resonant cavities is linearly proportional to an adjustable voltage connected to a connection node of thermal phase shifters in adjacent resonator stages, thereby simplifying the control method for the resonator system and reducing the number of control voltages required.

To achieve the above objective, the resonator system according to the present invention includes at least N resonator stages cascaded, wherein N is an integer greater than 1, each of the resonator stages includes a resonant cavity and a thermal phase shifter. In each resonator stage, the thermal phase shifter is integrated on the resonant cavity. The thermal phase shifters in the N resonator stages cascaded are sequentially connected in series. A first end of the thermal phase shifter in a first resonator stage is connected to a preset voltage, a second end of the thermal phase shifter in an $N^{th}$ resonator stage is grounded, and a connection node of the thermal phase shifters in adjacent resonator stages is connected to an adjustable voltage; and resistances of the thermal phase shifters in the N resonator stages are all equal.

The resonator system according to the present invention has the following beneficial effects: it is achieved that a change in a phase difference between two adjacent resonant cavities can be linearly proportional to the adjustable voltage connected to the connection node of the thermal phase shifters in the adjacent resonator stages, thereby simplifying the control method for the resonator system and reducing the number of control voltages required.

Optionally, the resonators include any one of micro-resonators, fiber optic ring resonators, Bragg gratings, photonic crystal nanobeams, Fabry-Perot cavities, or Mach-Zender interferometers.

Optionally, the resonators are the micro-resonators, each of the resonator stages further includes an optical waveguide; in each of the resonator stages, the micro-resonator cavity is coupled to the optical waveguide, and the micro-resonator cavity in a previous micro-resonator stage is coupled to the optical waveguide in a next resonator stage.

Optionally, an $N^{th}$ micro-resonator stage further includes an output waveguide, the output waveguide being coupled to the micro-resonator cavity in the $N^{th}$ micro-resonator stage.

Optionally, the resonators are the micro-ring resonators, and a coupling region of each of the micro-resonators includes any one of a directional coupler, a bent directional coupler, an adiabatic coupler, a multimode interferometer coupler, and a splitting ratio adjustable coupler.

Optionally, the resonators are the micro-ring resonators, the micro-ring resonators being annular, racetrack-shaped, Taiji shaped, or 8-shaped.

The present invention further provides a tunable laser including the resonator system and a gain chip, wherein one end of an $N^{th}$ resonator stage in the resonator system is connected to the gain chip.

Optionally, the tunable laser further includes a total reflection loop, wherein one end of a first resonator stage in the resonator system is connected to the total reflection loop, and the one end of the $N^{th}$ resonator stage in the resonator system is connected to the gain chip.

The tunable laser according to the present invention has the following beneficial effects: it is achieved that a change in a phase difference between adjacent resonant cavities can be linearly proportional to an adjustable voltage connected to a connection node of thermal phase shifters in adjacent resonator stages, thereby simplifying a control method for the resonator system and reducing the number of control voltages required.

The present invention further provides a control method for a resonator system, wherein when N >= 3, the control method includes the following steps:

S0: fixing the preset voltage to be V0;

S1: controlling adjustable voltages connected to connection nodes from a second connection node to an $(N-1)^{th}$ connection node to be all 0;

S2: controlling an adjustable voltage connected to a first connection node to be greater than or equal to 0 and less than or equal to V0, and fixing the adjustable voltage connected to the first connection node;

S3: setting adjustable voltages connected to connection nodes after an $M^{th}$ connection node to be all 0, controlling an adjustable voltage connected to the $M^{th}$ connection node to be greater than or equal to 0 and less than or equal to an adjustable voltage connected to an $(M-1)^{th}$ connection node, and fixing the adjustable voltage connected to the $M^{th}$ connection node; and

S4: repeatedly performing step S3 by setting M to be integers from 2 to N-1 in sequence.

The control method for the resonator system according to the present invention has the following beneficial effects: when the number of resonator stages cascaded in the resonator system is greater than or equal to 3, it is achieved that a change in a phase difference between adjacent resonant cavities can be linearly proportional to an adjustable voltage connected to a connection node of thermal phase shifters in adjacent resonator stages, thereby simplifying the control method for the resonator system.

Optionally, adjustable voltages connected to connection nodes between thermal phase shifters of adjacent resonators are controlled to change in descending order from a first stage to an $N^{th}$ stage, the preset voltage is greater than an adjustable voltage connected to a connection node of the thermal phase shifter in the first resonator stage and the thermal phase shifter in a second resonator stage, and an adjustable voltage connected to a connection node of the thermal phase shifter in an $(N-1)^{th}$ resonator stage and the thermal phase shifter in the $N^{th}$ resonator stage is greater than 0.

The present invention further provides a control method for the resonator system, where when N = 2, the control method includes the following steps:

fixing the preset voltage to be V0; and

controlling the adjustable voltage connected to the connection node to be greater than or equal to 0 and less than or equal to V0, and fixing the adjustable voltage connected to the connection node.

The control method for the resonator system according to the present invention has the following beneficial effects: when the number of resonator stages cascaded in the resonator system is equal to 2, it is achieved that a change in a phase difference between adjacent resonant cavities can be linearly proportional to an adjustable voltage connected to a connection node of thermal phase shifters in adjacent resonator stages, thereby simplifying the control method for the resonator system and reducing the number of control voltages required.

## BRIEF DESCRIPTION OF THE DRAWINGS

FIG. 1 is a schematic diagram of tunable micro-resonators based on a vernier effect in the prior art;

FIG. 2 is an output spectrum of a vernier micro-resonator at voltages V1 and V2 in the prior art;

FIG. 3 is a schematic diagram of a micro-resonator system in some embodiments of the present invention;

FIG. 4 is a diagram of a relationship between a central wavelength of an output spectrum of a micro-resonator and a change in a refractive index of a waveguide generated by a control voltage in some embodiments of the present invention;

FIG. 5 is a schematic diagram of a cascading mode of micro-resonators in some embodiments of the present invention;

FIG. 6 is a schematic diagram of a cascading mode of micro-resonators in some other embodiments of the present invention;

FIG. 7 is a schematic diagram of a cascading mode of micro-resonators in yet some embodiments of the present invention;

FIG. 8 is a schematic diagram of a cascading mode of micro-resonators in some further embodiments of the present invention;

FIG. 9 is a schematic diagram of a micro-resonator system with four micro-resonator stages in some embodiments of the present invention;

FIG. 10 is a schematic diagram of a tunable laser in some embodiments of the present invention;

FIG. 11 is a schematic diagram of a tunable laser in some other embodiments of the present invention;

FIG. 12 is a schematic diagram of a tunable laser in another embodiments of the present invention;

FIG. 13 is a schematic diagram of change of an output wavelength of a laser at different control voltages of the tunable laser in some embodiments of the present invention;

FIG. 14 is a flowchart of a control method for a resonator system in some embodiments of the present invention; and

FIG. 15 is a flowchart of a control method for a resonator system in some other embodiments of the present invention.

## DETAILED DESCRIPTION OF THE EMBODIMENTS

To make the objective, technical solutions and advantages of the present invention clearer, the technical solutions in the embodiments of the present invention will be clearly and completely described below with reference to the accompanying drawings of the present invention. Apparently, the embodiments described are some rather than all of the embodiments of the present invention. All other embodiments obtained by those of ordinary skill in the art based on the embodiments of the present invention without creative efforts shall fall within the scope of protection of the present invention. The technical or scientific terms used herein shall have the usual meanings understood by those of ordinary skill in the art to which the present invention belongs, unless otherwise defined. The similar term such as "include/comprise" refers to that an element or item that appears before the term covers elements or items listed after the term and their equivalents, without excluding other elements or items.

In view of the problems in the prior art, an embodiment of the present invention provides a resonator system including N resonator stages cascaded or N micro-resonator stages cascaded, wherein N is an integer greater than 1. Each of the resonator stages or the micro-resonator stages includes a resonant cavity and a thermal phase shifter. In each of the resonator stages or the micro-resonator stages, the thermal phase shifter is integrated on the resonant cavity, the thermal phase shifters in the N resonator stages cascaded are sequentially connected in series. A first end of the thermal phase shifter in a first resonator stage is connected to a preset voltage, a second end of the thermal phase shifter in an $N^{th}$ resonator stage is grounded, and a connection node of the thermal phase shifters in adjacent resonator stages is connected to an adjustable voltage; and resistances of the thermal phase shifters in the N resonator stages are all equal.

In the resonator system according to the present invention, the first end of the thermal phase shifter in the first resonator stage is connected to the preset voltage, the second end of the thermal phase shifter in the $N^{th}$ resonator stage is grounded, and the connection node of the thermal phase shifters in the adjacent resonator stages is connected to the adjustable voltage. The resistances of the thermal phase shifters in the N resonator stages are all equal, such that it is achieved that a change in a phase difference between adjacent resonant cavities can be linearly proportional to the adjustable voltage connected to the connection node of the thermal phase shifters in the adjacent resonator stages, thereby simplifying a control method for the resonator system and reducing the number of control voltages required.

In some embodiments, the resonators include any one of micro-ring resonators, fiber optic ring resonators, Bragg gratings, photonic crystal nanobeams, Fabry-Perot cavities, or Mach-Zender interferometers.

In some embodiments, the resonators are the micro-ring resonators; each of the resonator stage or micro-resonator stage further includes an optical waveguide, in each of the N micro-resonator stages, a micro-resonator cavity is coupled to the optical waveguide, and the micro-resonator cavity in a previous resonator stage or micro-resonator stage is coupled to the optical waveguide in a next resonator stage or micro-resonator stage.

In some embodiments, an $N^{th}$ resonator stage or micro-resonator stage further includes an output waveguide, the output waveguide being coupled to the micro-resonator cavity in the $N^{th}$ resonator stage or micro-resonator stage.

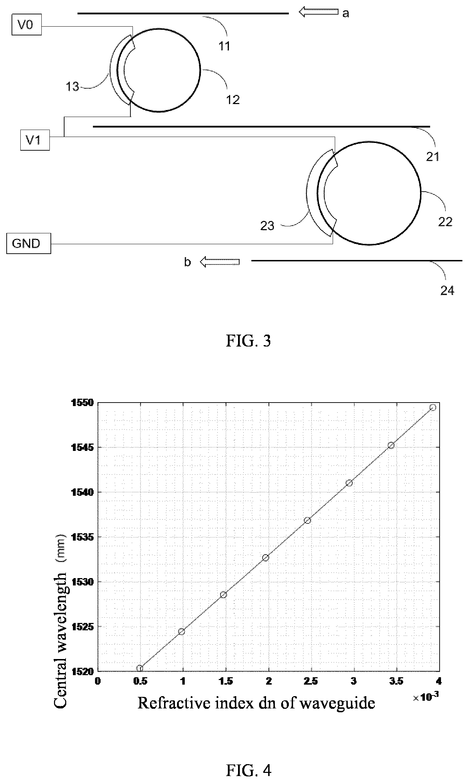

FIG. 3 is a schematic diagram of a micro-resonator system in some embodiments of the present invention. Referring to FIG. 3, the micro-resonator system includes at least a first micro-resonator stage and a second micro-resonator stage that are cascaded. The first micro-resonator stage includes a first optical waveguide 11, a first micro-resonator cavity 12 and a first thermal phase shifter 13, and the second micro-resonator stage includes a second optical waveguide 21, a second micro-resonator cavity 22, a second thermal phase shifter 23 and an output optical waveguide 24, wherein the first thermal phase shifter 13 is integrated on the first micro-resonator cavity 12, the second thermal phase shifter 23 is integrated on the second micro-resonator cavity 22, the first micro-resonator cavity 12 is coupled to the first optical waveguide 11 and the second optical waveguide 21, the second micro-resonator cavity 22 is coupled to the second optical waveguide 21 and the output optical waveguide 24. The arrow with a label "a" is a light transmission direction of an input optical path in the first optical waveguide 11, and the arrow with a label "b" is a light transmission direction of an output optical path in the output optical waveguide 24. The first thermal phase shifter 13 has a first resistance R1, the second thermal phase shifter 23 has a second resistance R2, wherein the first resistance R1 is the same as the second resistance R2, the first thermal phase shifter 13 is connected in series to the second thermal phase shifter 23, a first end of the first thermal phase shifter 13 is connected to a preset voltage V0, a second end of the second thermal phase shifter 23 is connected to a ground pin GND (with a voltage of 0 V), and a connection node of the first thermal phase shifter 13 and the second thermal phase shifter 23 is connected to a first voltage V1, wherein the first voltage V1 is an adjustable voltage, and the preset voltage V0 is a fixed voltage. In some embodiments of the present invention, the resonator system includes at least a first resonator stage and a second resonator stage that are cascaded, wherein each resonator stage includes a resonant cavity and a thermal phase shifter. In each resonator stage, the thermal phase shifter is integrated on the resonant cavity, the thermal phase shifters in the first resonator stage and the second resonator stage that are cascaded are sequentially connected in series, a first end of the thermal phase shifter in the first resonator stage is connected to a preset voltage, a second end of the thermal phase shifter in the second resonator stage is grounded, and a connection node of the thermal phase shifters in the first resonator stage and the second resonator stage that are cascaded is connected to an adjustable voltage V1; and resistances of the thermal phase shifters in the first resonator stage and the second resonator stage are all the same. That is to say, in the above embodiment, the resonator system at least partly includes two thermal phase shifters coupled to the resonant cavities have the same resistance, a common end or node of the two thermal phase shifters is connected to an adjustable voltage V1, and the other ends of the two thermal phase shifters are connected to a fixed voltage V0 and the ground respectively; and the resonator system may include other parts which are not limited to the above described.

In some specific embodiments, the light transmission direction, the arrow with a label "a", of the input optical path in the first optical waveguide 11 and the light transmission direction, the arrow with a label "b", of the output optical path in the output optical waveguide 24 are the same.

A working principle of the resonator system according to the present invention is illustrated using this embodiment as an example. A relationship between a phase difference $\Delta\varphi$ between the first micro-resonator cavity and the second micro-resonator cavity and the first voltage V1 connected to the connection node of the first thermal phase shifter 13 and the second thermal phase shifter 23 is shown by a formula 1 as follows:

$$\text{Formula 1: } \Delta\varphi = A\left(\frac{(V0-V1)^2}{R1} - \frac{(V1-0)^2}{R1}\right) = A\left(\frac{V0^2}{R1} - \frac{2V0}{R1}V1\right)$$

Wherein A is a first coefficient, the first coefficient is determined by the properties of waveguides such as a waveguide material and a waveguide structure.

From the formula 1, it can be seen that due to the cancellation of items $\frac{V1^2}{R1}$, the phase difference $\Delta\varphi$ between the two adjacent micro-resonant cavities is directly proportional to the adjustable voltage V1 applied to the connection node of the thermal phase shifters, i.e., the first thermal phase shifter 13 and the second thermal phase shifter 23 on the two adjacent micro-resonant cavities. The beneficial effects are as follows: merely one control voltage is needed, and the phase difference $\Delta\varphi$ to be achieved is linearly proportional to the control voltage V1 (instead of V1$^2$) that needs to be provided, easing the control of the micro-resonator system. FIG. 4 is a diagram of a relationship between a central wavelength of an output spectrum of a micro-resonator and a change in a refractive index of a waveguide generated by a control voltage in some embodiments of the present invention. Referring to Fig. 4, by using a simulation result as an example, the central wavelength of the output spectrum of the micro-resonator is directly proportional to the change in the refractive index of the waveguide generated by the control voltage.

wherein A is a first coefficient, the first coefficient A is determined by the properties of waveguide material and structure and is measurable. This coefficient is well-known in the industry and will not be repeated herein.

In some embodiments, the micro-resonators are annular, runway-shaped, Tai ji symbol-shaped, or splayed.

In some embodiments, a coupling region of the micro-resonator is any one of a directional coupler, a bent directional coupler, an adiabatic coupler, a multimode interferometer, or a splitting ratio adjustable coupler.

In some embodiments, a heating resistor material of the thermal phase shifter includes titanium nitride, doped silicon, or tungsten.

In some embodiments, an integrated material platform at which the micro-resonators is located includes bulk silicon, silicon on insulator, silicon on sapphire, silicon dioxide, aluminum nitride, indium phosphide, lithium niobate, or polymer.

In some embodiments, a waveguide of the micro-resonator includes a channel waveguide, a ridge waveguide, a slot waveguide, a diffused waveguide, and a photonic crystal waveguide.

In some embodiments, an operating wavelength range of the micro-resonator includes a visible band, an O band, an E band, an S band, a C band, an L band, a U band, and a mid-infrared band.

In some embodiments, the micro-resonator is in the form of an optical resonator system including an integrated chip, an optical fiber, or a freeform optical component.

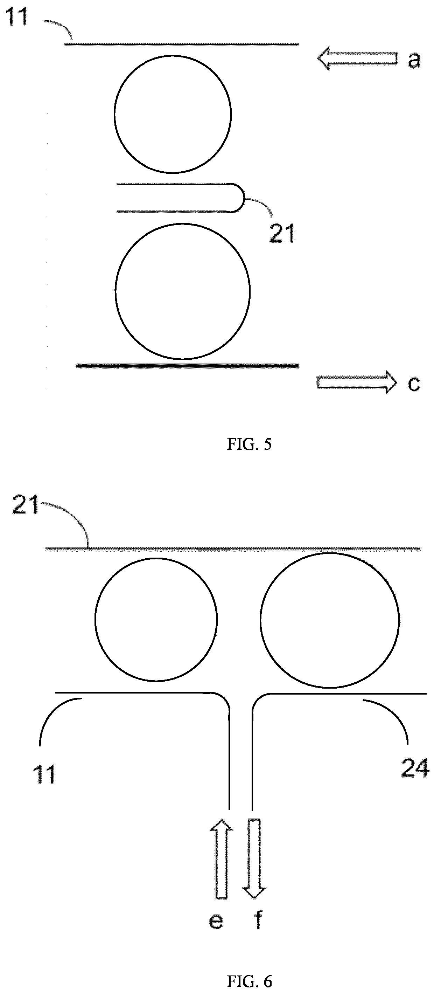

FIG. 5 is a schematic diagram of a cascading mode of micro-resonators in some embodiments of the present invention. Referring to FIG. 5, an optical light transmission direction of the second optical waveguide 21 is turned 180°, the arrow with a label "a" is a light transmission direction of an input optical path in the first optical waveguide 11, and , the arrow with a label "c" is a light transmission direction of an output optical path in the output optical waveguide 24.

In some specific embodiments, the light transmission direction a of the input optical path in the first optical waveguide 11 and the light transmission direction c of the output optical path in the output optical waveguide 24 are opposite or at any angle.

FIG. 6 is a schematic diagram of a cascading mode of micro-resonators in some other embodiments of the present invention. Referring to FIG. 6, the first optical waveguide 11 and the output optical waveguide 24 are bent, e is a light transmission direction of an input optical path in the first optical waveguide 11, and f is a light transmission direction of an output optical path in the output optical waveguide 24.

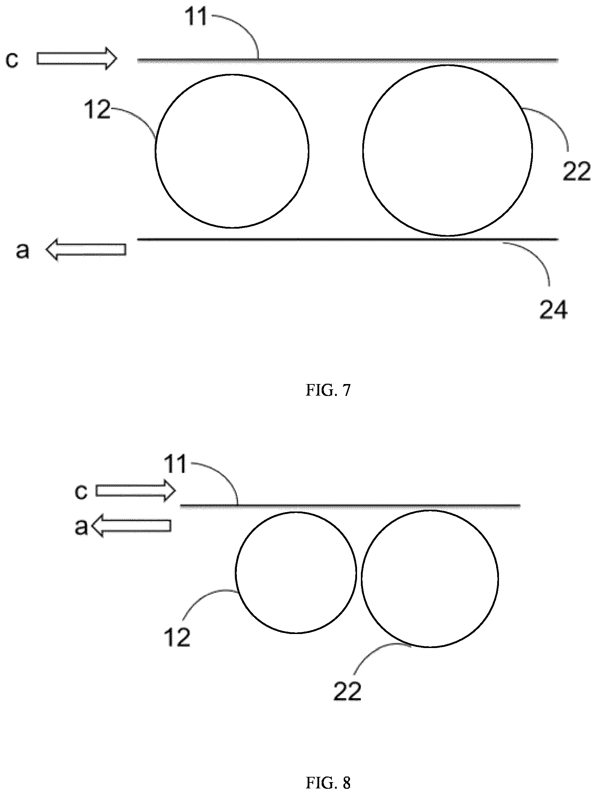

FIG. 7 is a schematic diagram of a cascading mode of micro-resonators in yet some embodiments of the present invention. Referring to FIG. 7, the first micro-resonator cavity 12 and the second micro-resonator cavity 22 are located between the first optical waveguide 11 and the output optical waveguide 24. The arrow with a label "c" is a light transmission direction of an input optical path in the first optical waveguide 11, and The arrow with a label "a" is a light transmission direction of an output optical path in the output optical waveguide 24.

FIG. 8 is a schematic diagram of a cascading mode of micro-resonators in some further embodiments of the present invention. Referring to FIG. 8, the first micro-resonator cavity 12 and the second micro-resonator cavity 22 are both coupled to the first optical waveguide 11 and are coupled to each other, the arrow with a label "c" is a light transmission direction of an input optical path in the first optical waveguide 11, and the arrow with a label "a" is a light transmission direction of an output optical path in the output optical waveguide 11.

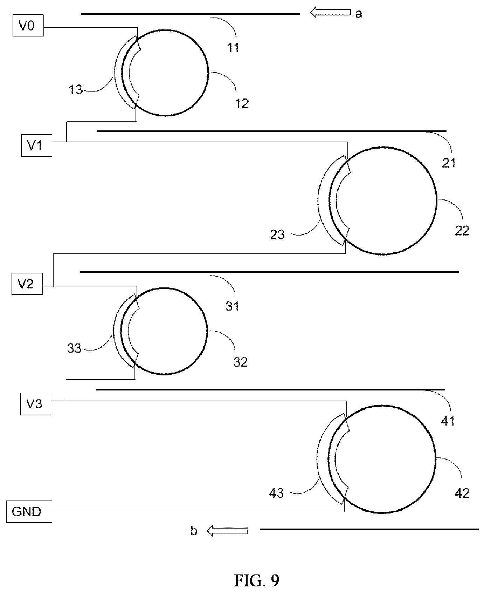

FIG. 9 is a schematic diagram of a micro-resonator system with four micro-resonator stages in some embodiments of the present invention. Referring to FIG. 9, the micro-resonator system includes four resonator stages cascaded, wherein in each resonator stage the thermal phase shifter is integrated on the micro-resonator cavity, and a first thermal phase shifter 13, a second thermal phase shifter 23, a third thermal phase shifter 33 and a fourth thermal phase shifter 43 in the four resonator stages cascaded are sequentially connected in series. A first end of the first thermal phase shifter 13 in a first resonator stage is connected to a preset voltage V0, a second end of the fourth thermal phase shifter 43 in the fourth resonator stage is connected to a ground pin GND (with a voltage of 0 V), a connection node of the first thermal phase shifter 13 and the second thermal phase shifter 23 is connected to a first voltage V1, a connection node of the second thermal phase shifter 23 and the third thermal phase shifter 33 is connected to a second voltage V2, and a connection node of the third thermal phase shifter 33 and the fourth thermal phase shifter 43 is connected to a third voltage V3, wherein the first voltage V1, the second voltage V2 and the third voltage V3 are all adjustable voltages; and resistances of the first thermal phase shifter 13, the second thermal phase shifter 23, the third thermal phase shifter 33 and the fourth thermal phase shifter 43 are the same. The arrow with a label "a" is a light transmission direction of an input optical path in the first optical waveguide 11, and the arrow with a label "b" is a light transmission direction of an output optical path in the output optical waveguide 24.-

The present invention further provides a tunable laser including the resonator system and a gain chip, wherein one end of an $N^{th}$ resonator stage in the resonator system is connected to the gain chip.

In some embodiments, the gain chip is an III-V chip.

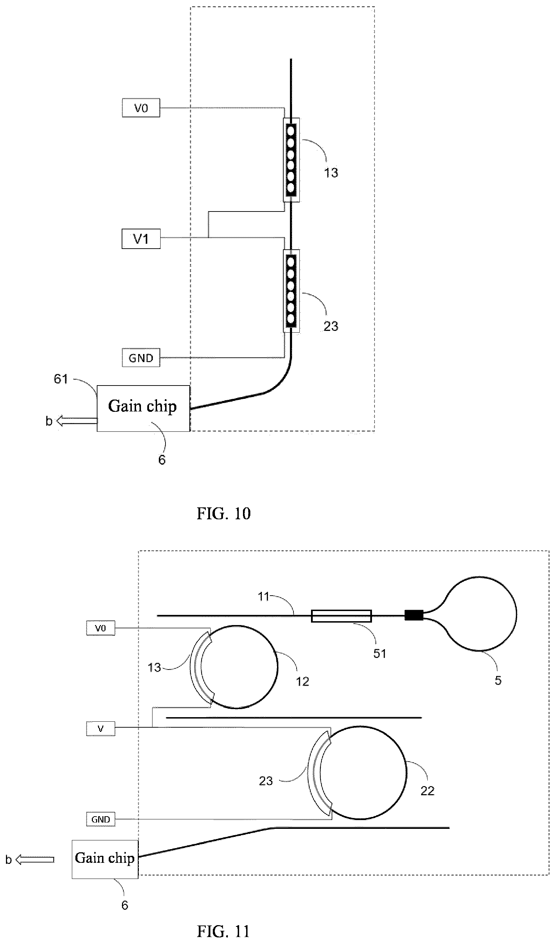

FIG. 10 is a schematic diagram of a tunable laser in some embodiments of the present invention. Referring to FIG. 10, the tunable laser includes the photonic crystal nanobeam resonator system and a gain chip 6, wherein a left side surface 61 of the gain chip 6 is a wholly-reflection surface such that light is emitted from the other end of the resonator system. The arrow with a label "c" is an output direction of an optical path. The resonator system is configured to adjust an output wavelength of the laser.

FIG. 11 is a schematic diagram of a tunable laser in some other embodiments of the present invention. Referring to FIG. 11, the tunable laser includes the micro-ring resonator system, a wholly-reflection loop 5 and a gain chip 6, wherein one end of a first resonator stage in the resonator system is connected to the wholly-reflection loop 5, and one end of an $N^{th}$ resonator stage in the resonator system is connected to the gain chip 6. The arrow with a label "b" is an output direction of an optical path. It is noted that neither of two ends of the gain chip 6 in this embodiment are wholly-reflection surfaces. The resonator system is configured to adjust an output wavelength of the laser.

In some embodiments, the tunable laser further includes a thermal phase shifter, the thermal phase shifter being integrated between the wholly-reflection loop and the resonator system and being configured to perform phase control outside the resonator system.

Specifically, referring to FIG. 11, the wholly-reflection loop 5 is connected to a right end of the first optical waveguide 11 on which an initial thermal phase shifter 51 is integrated.

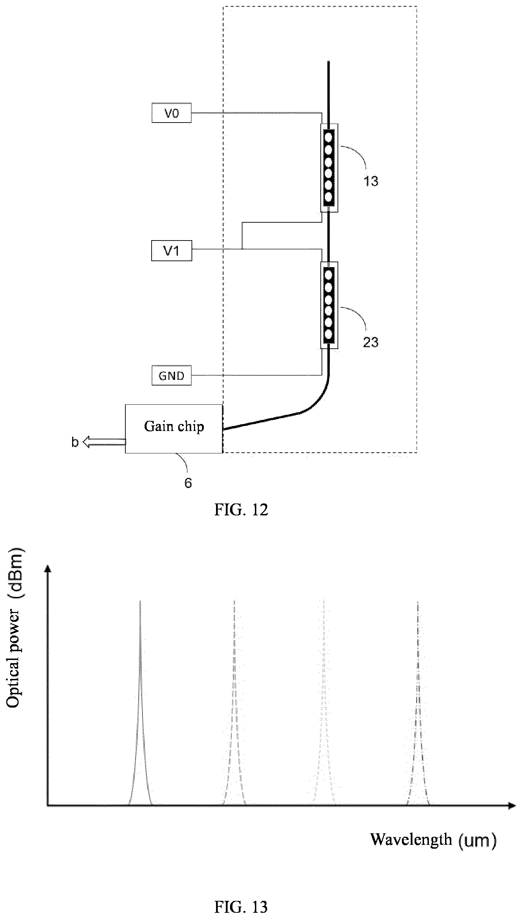

FIG. 12 is a schematic diagram of a tunable laser in yet some embodiments of the present invention. Referring to FIG. 12, the resonator system is a vernier photonic crystal nanobeam resonator including two photonic crystal nanobeams on which a first thermal phase shifter and a second thermal phase shifter are integrated respectively, wherein the first thermal phase shifter 13 has a first resistance R1, the second thermal phase shifter 23 has a second resistance R2, the first resistance R1 is the same as the second resistance R2, the first thermal phase shifter 13 is connected in series to the second thermal phase shifter 23, a first end of the first thermal phase shifter 13 is connected to a preset voltage V0, a second end of the second thermal phase shifter 23 is connected to a ground pin GND (with a voltage of 0 V), and a connection node of the first thermal phase shifter 13 and the second thermal phase shifter 23 is connected to a first voltage V1, wherein the first voltage V1 is an adjustable voltage, and the preset voltage V0 is a fixed voltage. One end of the resonator system is connected to a gain chip 6. The arrow with a label "b" is a light transmission direction of an output optical path of the tunable laser. It is noted that neither of two ends of the gain chip 6 in this embodiment are wholly-reflection surfaces. The resonator system is configured to adjust an output wavelength of the laser.

FIG. 13 is a schematic diagram of change of an output wavelength of a laser at different control voltages of the tunable laser in some embodiments of the present invention. Referring to FIG. 13, under the control of voltages having a change with a same step size, the tunable laser, from left to right, outputs four different spectra, the four spectra having a same amount of change in wavelength. A control method for the tunable laser according to the present invention enables a change in a phase difference between two adjacent resonant cavities to be linearly proportional to an adjustable voltage connected to a connection node of thermal phase shifters in adjacent resonator stages, thereby simplifying a control method for resonators and reduces the number of control voltages required.

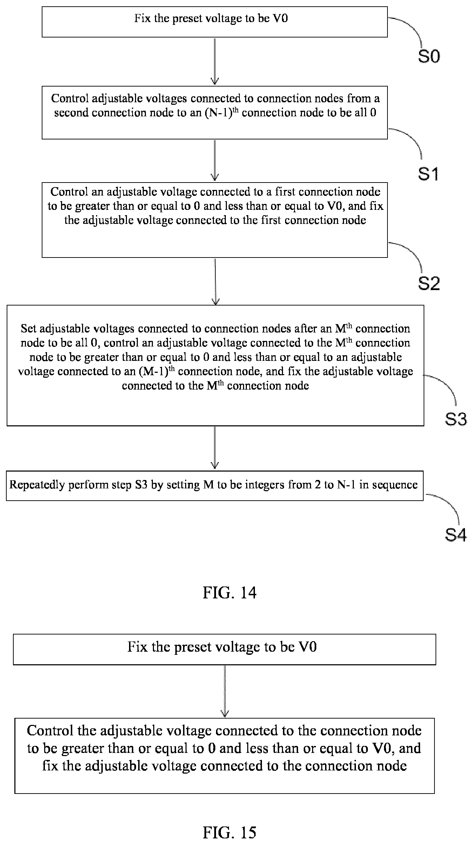

FIG. 14 is a flowchart of a control method for a resonator system in some embodiments of the present invention. A first end of the thermal phase shifter in the first resonator stage is connected to the preset voltage, and the second end of the thermal phase shifter in the $N^{th}$ resonator stage is grounded. N-1 connection nodes are provided between N thermal phase shifters, the N-1 connection nodes being connected to N-1 adjustable voltages respectively. When N >= 3, referring to FIG. 14, the control method includes the following steps:

S0: fixing the preset voltage to be V0;

S1: controlling adjustable voltages connected to connection nodes from a second connection node to an $(N-1)^{th}$

connection node to be all 0;

S2: controlling an adjustable voltage connected to a first connection node to be greater than or equal to 0 and less than or equal to V0, and fixing the adjustable voltage connected to the first connection node;

S3: setting adjustable voltages connected to connection nodes after an $M^{th}$ connection node to be all 0, controlling an adjustable voltage connected to the $M^{th}$ connection node to be greater than or equal to 0 and less than or equal to an adjustable voltage connected to an $(M-1)^{th}$ connection node, and fixing the adjustable voltage connected to the $M^{th}$ connection node; and

S4: repeatedly performing step S3 by setting M to be integers from 2 to N-1 in sequence.

The control method for the resonator system according to the present invention enables, when the number of resonator stages cascaded in the resonator system is greater than or equal to 3, a change in a phase difference between two adjacent resonant cavities to be linearly proportional to an adjustable voltage connected to a connection node of thermal phase shifters in adjacent resonator stages, which simplifies the control method for the resonator system and reduces the number of control voltages required.

In some embodiments, methods for controlling and fixing the adjustable voltage in the step S2 and the step S3 both include: scanning the voltage, observing an output spectrum of the resonator system, and enabling the spectrum to meet expected characteristics, such as controlling the adjustable voltage to move a central wavelength to a target wavelength.

In some embodiments, adjustable voltages connected to connection nodes between thermal phase shifters of adjacent resonators are controlled to change in descending order from a first stage to an $N^{th}$ stage, the preset voltage is greater than an adjustable voltage connected to a connection node of the thermal phase shifter in the first resonator stage and the thermal phase shifter in a second resonator stage, and an adjustable voltage connected to a connection node of the thermal phase shifter in the $(N-1)^{th}$ resonator stage and the thermal phase shifter in the $N^{th}$ resonator stage is greater than 0.

In some specific embodiments, referring to FIG. 9, the micro-resonator system includes four micro-resonators stages cascaded, a voltage connected to a first connection node is V1, a voltage connected to a second connection node is V2, and a voltage connected to a third connection node is V3. The control method includes the following steps:

S0: fixing the preset voltage to be V0;

S10: controlling adjustable voltages connected to connection nodes from a second connection node to a fourth connection node to be all 0;

S20: controlling V1 to be greater than or equal to 0 and less than or equal to V0, and fixing V1;

S30: controlling adjustable voltages connected to connection nodes from a third connection node to the fourth connection node to be both 0;

S40: controlling V2 to be greater than or equal to 0 and less than or equal to V1, and fixing V2; and

S50: controlling V3 to be greater than or equal to 0 and less than or equal to V2, and fixing V3.

Referring to FIG. 9, the micro-resonator system includes four micro-resonators stages cascaded, and the preset voltage V0, the first voltage V1, the second voltage V2, the third voltage V3 and the voltage (the voltage being 0) of GND meet $V0 \geq V1 \geq V2 \geq V3 \geq 0$.

FIG. 15 is a flowchart of a control method for a resonator system in some other embodiments of the present invention. When N = 2, one connection node is provided between two thermal phase shifters, the one connection node being connected to one adjustable voltage. Referring to FIG. 15, the control method includes the following steps:

fixing the preset voltage to be V0; and

controlling the adjustable voltage connected to the connection node to be greater than or equal to 0 and less than or equal to V0, and fixing the adjustable voltage connected to the connection node.

The control method for the resonator system according to the present invention enables, when the number of resonator stages cascaded in the resonator system is equal to 2, a change in a phase difference between two adjacent resonant cavities is linearly proportional to an adjustable voltage connected to a connection node of thermal phase shifters in adjacent resonator stages, which simplifies the control method for the resonator system.

Although the embodiments of the present invention have been described in detail above, it is apparent to those skilled in the art that various modifications and variations can be made to these embodiments. However, it is to be understood that such modifications and variations all fall within the scope and spirit of the present invention as described in the claims. Moreover, the present invention described herein may have other embodiments and may be carried out or implemented in various ways.

**Claims**

1. A resonator system, comprising at least N resonator stages cascaded, wherein N is an integer greater than 1; each of the resonator stages comprises a resonant cavity and a thermal phase shifter; in each of the resonator stages, the thermal phase shifter is integrated on the resonant cavity; the thermal phase shifters in the N resonator stages cascaded are sequentially connected in series; a first end of the thermal phase shifter in a first resonator stage is connected to a preset voltage, a second end of the thermal phase shifter in an $N^{th}$ resonator stage is grounded, and a connection node of the thermal phase shifters in adjacent resonator stages is connected to an adjustable voltage; and resistances of the thermal phase shifters in the N resonator stages are all equal.

2. The resonator system according to claim 1, wherein the resonators comprise any one of micro-ring resonators, fiber optic ring resonators, Bragg gratings, photonic crystal nanobeams, Fabry-Perot cavities, or Mach-Zender interferometers.

3. The resonator system according to claim 2, wherein the resonators are the micro-ring resonators; each of the resonator stages further comprises an optical waveguide; in each of the resonator stages, a micro-resonator cavity is coupled to the optical waveguide; and the micro-resonator cavity in a previous resonator stage is coupled to the optical waveguide in a next resonator stage.

4. The resonator system according to claim 3, wherein an $N^{th}$ resonator stage further comprises an output waveguide, the output waveguide being coupled to the micro-resonator cavity in the $N^{th}$ resonator stage.

5. The resonator system according to claim 2, wherein the resonators are the micro-ring resonators, and a coupling region of each of the micro-ring resonators comprises any one of a directional coupler, a bent directional coupler, an adiabatic coupler, a multimode interferometer, and a splitting ratio adjustable coupler.

6. The resonator system according to claim 2, wherein the resonators are micro-ring resonators, the micro-ring resonators being annular, runway-shaped, Tai ji symbol-shaped, or splayed.

7. A tunable laser, comprising the resonator system according to claim 1 and a gain chip, wherein one end of an $N^{th}$ resonator stage in the resonator system is connected to the gain chip.

8. The tunable laser according to claim 7, further comprising a total reflection loop, wherein one end of a first resonator stage in the resonator system is connected to the total reflection loop, and the one end of the $N^{th}$ resonator stage in the resonator system is connected to the gain chip.

9. A control method for the resonator system according to claim 1, wherein when N >= 3, the control method comprises the following steps:

S0: fixing the preset voltage to be V0;
S1: controlling adjustable voltages connected to connection nodes from a second connection node to an $(N-1)^{th}$ connection node to be all 0;
S2: controlling an adjustable voltage connected to a first connection node to be greater than or equal to 0 and less than or equal to V0, and fixing the adjustable voltage connected to the first connection node;
S3: setting adjustable voltages connected to connection nodes after an $M^{th}$ connection node to be all 0, controlling an adjustable voltage connected to the $M^{th}$ connection node to be greater than or equal to 0 and less than or equal to an adjustable voltage connected to an $(M-1)^{th}$ connection node, and fixing the adjustable voltage connected to the $M^{th}$ connection node; and

S4: repeatedly performing step S3 by setting M to be integers from 2 to N-1 in sequence.

10. The control method according to claim 9, wherein adjustable voltages connected to connection nodes between thermal phase shifters of adjacent resonators are controlled to change in descending order from a first stage to an $N^{th}$ stage, the preset voltage is greater than an adjustable voltage connected to a connection node of the thermal phase shifter in the first resonator stage and the thermal phase shifter in a second resonator stage, and an adjustable voltage connected to a connection node of the thermal phase shifter in an $(N-1)^{th}$ resonator stage and the thermal phase shifter in the $N^{th}$ resonator stage is greater than 0.

11. A control method for the resonator system according to claim 1, wherein when N = 2, the control method comprises the following steps:

fixing the preset voltage to be V0; and
controlling the adjustable voltage connected to the connection node to be greater than or equal to 0 and less than or equal to V0, and fixing the adjustable voltage connected to the connection node.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

Fix the preset voltage to be V0

S0

Control adjustable voltages connected to connection nodes from a second connection node to an (N-1)th connection node to be all 0

S1

Control an adjustable voltage connected to a first connection node to be greater than or equal to 0 and less than or equal to V0, and fix the adjustable voltage connected to the first connection node

S2

Set adjustable voltages connected to connection nodes after an Mth connection node to be all 0, control an adjustable voltage connected to the Mth connection node to be greater than or equal to 0 and less than or equal to an adjustable voltage connected to an (M-1)th connection node, and fix the adjustable voltage connected to the Mth connection node

S3

Repeatedly perform step S3 by setting M to be integers from 2 to N-1 in sequence

S4

FIG. 14

Fix the preset voltage to be V0

Control the adjustable voltage connected to the connection node to be greater than or equal to 0 and less than or equal to V0, and fix the adjustable voltage connected to the connection node

FIG. 15

## INTERNATIONAL SEARCH REPORT

| International application No. |
| --- |
| **PCT/CN2022/144399** |

**A.    CLASSIFICATION OF SUBJECT MATTER**

G02B6/293(2006.01)i;   H01S3/08(2023.01)i

According to International Patent Classification (IPC) or to both national classification and IPC

**B.    FIELDS SEARCHED**

Minimum documentation searched (classification system followed by classification symbols)

IPC: G02B, H01S, H04B, G02F, H01P

Documentation searched other than minimum documentation to the extent that such documents are included in the fields searched

Electronic data base consulted during the international search (name of data base and, where practicable, search terms used)

CNTXT, ENTXT, VEN, CNKI, IEEE: 谐振器, 环, 热移相, 电压, 可调, 调节, 控制, 可控, resonator, ring, thermal phase shifter, voltage, adjust, control

**C.    DOCUMENTS CONSIDERED TO BE RELEVANT**

| Category* | Citation of document, with indication, where appropriate, of the relevant passages | Relevant to claim No. |
| --- | --- | --- |
| A | CN 113985521 A (SHANGHAI JIAO TONG UNIVERSITY) 28 January 2022 (2022-01-28) description, paragraphs [0004]-[0040] | 1-11 |
| A | CN 115437070 A (NO.54 RESEARCH INSTITUTE OF CHINA ELECTRONICS TECHNOLOGY GROUP CORPORATION et al.) 06 December 2022 (2022-12-06) entire document | 1-11 |
| A | US 2017149508 A1 (CORIANT ADVANCED TECHNOLOGY, LLC) 25 May 2017 (2017-05-25) entire document | 1-11 |
| A | CN 101799608 A (SHANGHAI JIAO TONG UNIVERSITY) 11 August 2010 (2010-08-11) entire document | 1-11 |
| A | US 2022365377 A1 (NIPPON TELEGRAPH AND TELEPHONE CORPORATION) 17 November 2022 (2022-11-17) entire document | 1-11 |
| A | JP 2017015789 A (NIPPON TELEGRAPH AND TELEPHONE CORPORATION) 19 January 2017 (2017-01-19) entire document | 1-11 |

☑ Further documents are listed in the continuation of Box C.      ☑ See patent family annex.

| | |
| --- | --- |
| *      Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **25 August 2023** | **30 August 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

# EP 4 628 952 A1

**INTERNATIONAL SEARCH REPORT**

| International application No. |
| --- |
| **PCT/CN2022/144399** |

## C. DOCUMENTS CONSIDERED TO BE RELEVANT

| Category* | Citation of document, with indication, where appropriate, of the relevant passages | Relevant to claim No. |
| --- | --- | --- |
| A | RAMZA HARRY ET AL. "2-D Modes Analysis of Micro-Ring Resonator: In case of chemical vapor sensing"<br>*IEEE 2020 8th International Conference on Intelligent and Advanced Systems (ICIAS)*,<br>15 July 2021 (2021-07-15),<br>entire document | 1-11 |
| A | 刘子溪等 (LIU, Zixi et al.). "高线性度电光调制器研究进展 (Research Progress on High-Linearity Electro-Optical Modulators)"<br>*中国激光 (Chinese Journal of Lasers)*, Vol. 49, No. 12, 25 June 2022 (2022-06-25), 202-222<br>ISSN: 0258-7025,<br>entire document | 1-11 |

Form PCT/ISA/210 (second sheet) (July 2022)

## INTERNATIONAL SEARCH REPORT
### Information on patent family members

International application No.

**PCT/CN2022/144399**

| Patent document cited in search report | | | Publication date (day/month/year) | Patent family member(s) | | | Publication date (day/month/year) |
|---|---|---|---|---|---|---|---|
| CN | 113985521 | A | 28 January 2022 | None | | | |
| CN | 115437070 | A | 06 December 2022 | None | | | |
| US | 2017149508 | A1 | 25 May 2017 | US | 2020169325 | A1 | 28 May 2020 |
| | | | | US | 2019089462 | A1 | 21 March 2019 |
| | | | | US | 2018019821 | A1 | 18 January 2018 |
| | | | | US | 2019379460 | A1 | 12 December 2019 |
| | | | | WO | 2017087766 | A1 | 26 May 2017 |
| CN | 101799608 | A | 11 August 2010 | None | | | |
| US | 2022365377 | A1 | 17 November 2022 | JP | 7227535 | B2 | 22 February 2023 |
| | | | | WO | 2020261349 | A1 | 30 December 2020 |
| | | | | US | 2021186636 | A1 | 24 June 2021 |
| | | | | US | 2023098189 | A1 | 30 March 2023 |
| JP | 2017015789 | A | 19 January 2017 | JP | 6484128 | B2 | 13 March 2019 |

Form PCT/ISA/210 (patent family annex) (July 2022)